# EUROPEAN PATENT APPLICATION

(11) **EP 4 738 004 A1**
(43) Date of publication of application: **06.05.2026**
(21) Application number: 25190081.7
(22) Date of filing: 17.07.2025
(51) Int. Cl.: G03F 1/24

(54) **BLANKMASK AND PHOTOMASK FOR EUV LITHOGRAPHY WITH HARD MASK FILM CONTAINING CHROME AND NIOBIUM**

(30) Priority: 04.11.2024 KR 20240154514
(71) Applicant: S&S Tech Co., Ltd., Daegu 42714 (KR)
(72) Inventor: YUN, Jong-Won, 42714 Daegu (KR); YANG, Chul-Kyu, 42714 Daegu (KR); WOO, Mi-Kyung, 42714 Daegu (KR); PARK, Min-Kyu, 42714 Daegu (KR)
(74) Representative: ABG Intellectual Property Law, S.L.

(57) **Abstract**

The blank mask for EUV lithography has a structure in which a reflective film, a capping film, an absorber film, and a hard mask film are sequentially stacked on a substrate. The hard mask film is formed of a material containing chromium (Cr), niobium (Nb), oxygen (O), and nitrogen (N), allowing sufficient etching speed to be obtained even using only chlorine-based etching gas without oxygen (O₂). Accordingly, damage to the resist film caused by oxygen (O₂) is prevented, and damage to the capping film is prevented since the capping film is not exposed to oxygen (O₂) during the process of removing the hard mask film.

## Description

### CROSS-REFERENCE TO RELATED APPLICATIONS

This application is based on and claims priority under 35 U.S.C. §119 to Korean Patent Application No. 10-2024-0154514 filed on November 4, 2024 in the Korean Intellectual Property Office, the disclosure of which is incorporated by reference herein in its entirety.

### BACKGROUND

### Field

The present invention relates to a blankmask for EUV lithography with hard mask film and a photomask manufactured with the same.

### Description of the Related Art

EUV Lithography is a semiconductor device manufacturing technology that uses 13.5nm EUV exposure light. In EUV lithography, reflective type photomasks are used in the wafer exposure process.

A blankmask for manufacturing EUV photomasks has two films on a substrate: a reflective film that reflects EUV light and an absorber film that absorbs EUV light. The photomask is manufactured by patterning the absorber film of this blankmask, and is used to form patterns on the wafer using the contrast difference between the reflectance of the reflective film and the reflectance of the absorber film.

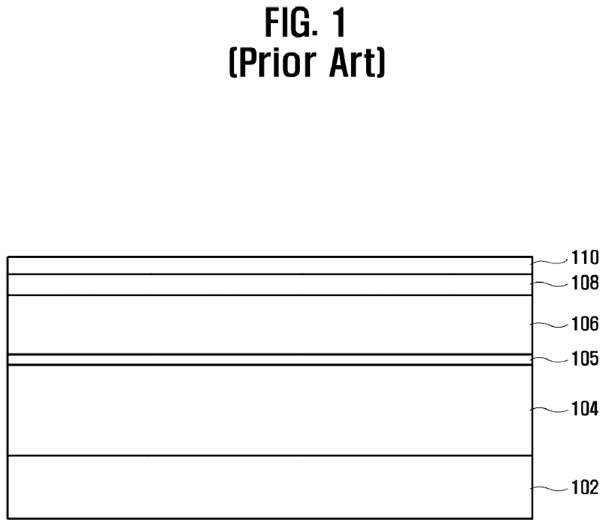

Figure 1 illustrates the structure of a blankmask for extreme ultraviolet lithography. The blankmask for extreme ultraviolet lithography comprises a substrate 102, a reflective film 104 formed on the substrate 102, a capping film 105 formed on the reflective film 104, an absorber film 106 formed on the capping film 105, a hard mask film 108 formed on the absorber film 106, and a resist film 110 formed on the hard mask film 108.

The reflective film 104 is generally formed in a multilayer structure where Mo material layers and Si material layers are alternately stacked 40 to 60 times. The capping film 105 is formed on top of the reflective film 104 and functions to protect the reflective film 104. The capping film 105 is generally formed of a material containing ruthenium (Ru) and functions to protect the reflective film 104 during etching for patterning of the absorber film 106. The absorber film 106 is generally formed of a material containing tantalum (Ta), and the hard mask film 108 is generally formed of a material containing chromium compounds, for example, chromium (Cr) with nitrogen (N), oxygen (O), etc. The absorber film 106 can have a structure of two or more layers, where the uppermost layer of the absorber film 106 consists of an inspection layer and the layer below the inspection layer consists of an absorber layer. The inspection layer is used for inspecting the completed blankmask using inspection light, and by being formed of a material containing tantalum (Ta) with oxygen (O), the inspection sensitivity to the wavelength of 193nm ArF inspection light is increased.

To manufacture a photomask, the resist film 110 is exposed to form a predetermined pattern, then used to etch and pattern the hard mask film 108, and the patterned hard mask film 108 is used as an etching mask to pattern the absorber film 106.

In the etching process for patterning the chromium (Cr)-based hard mask film 108, chlorine-based gas containing oxygen (O₂) is used. This etching process causes greater damage to the resist film 110 compared to etching processes using chlorine-based gas without oxygen (O₂). Considering this, the thickness of the resist film 110 must be increased, making it difficult to achieve the thinning of the resist film 110 needed for resolution improvement.

Also, in the process of patterning the absorber film 106 using the hard mask film 108, fluorine (F)-based etching gas is used for etching the inspection layer, which is the uppermost layer of the absorber film 106, and chlorine-based etching gas without oxygen (O₂) is used for etching the absorber layer, which is the layer below the uppermost layer of the absorber film 106. Since the hard mask film 108 is not etched when using chlorine-based gas without oxygen (O₂), an additional removal process using chlorine-based gas containing oxygen (O₂) is required to remove the hard mask film 108. In this case, the oxygen (O₂) contained in the etching gas causes oxidation of the capping film 105, resulting in decreased reflectance.

### SUMMARY

The present invention was devised to solve the above problems, and it is the object of the invention to enable etching of the hard mask film using etching gas without oxygen in the process of manufacturing photomasks using EUV blankmasks equipped with an absorber film and hard mask film, thereby enabling thinning of the resist film and consequently achieving high resolution.

Another object of the invention is to eliminate the need for additional etching process to remove the hard mask film pattern by ensuring that the hard mask film pattern is removed during the etching of the absorber film.

Still another object of the invention is to prevent damage to the capping film that occurs when using etching gas containing oxygen (O₂), thereby achieving high image contrast.

According to the present invention, sufficient hard mask film etching speed can be obtained using only chlorine-based etching gas without oxygen (O₂) in the process of manufacturing photomasks using EUV blankmasks equipped with an absorber film and hard mask film.

Accordingly, damage to the resist film caused by oxygen (O₂) is prevented, enabling thinning of the resist film. For example, even when the resist film is configured to have a thickness of 40nm or less, sufficient thickness for etching the hard mask film can be secured, thus resulting in improved pattern precision of the absorber film through improved pattern precision of the hard mask film. Also, since there is less damage to the resist film during the etching of the hard mask film, it is possible to over-etch the hard mask film. Therefore, the effect of improved pattern precision by over-etching can be obtained without making the resist film thicker than the conventional method.

Additionally, according to the invention, since the capping film is not exposed to oxygen (O₂) in the process of removing the hard mask film, reflectance reduction due to damage to the capping film is prevented, thereby improving image contrast.

### BRIEF DESCRIPTION OF THE DRAWINGS

FIG. 1 is a diagram illustrating the film structure of a conventional blankmask for extreme ultraviolet lithography.
FIG. 2 is a diagram illustrating the film structure of a blankmask for extreme ultraviolet lithography according to the present invention.

### DETAILED DESCRIPTION OF EXEMPLARY EMBODIMENTS

Hereinafter, the present invention will be described in more detail with reference to the accompanying drawings.

The blankmask of the present invention includes not only binary type blankmasks but also phase shift type blankmasks. In binary type blankmasks, the absorber film functions to absorb EUV exposure light, and in phase shift blankmasks, the absorber film inverts the phase of the exposure light to cause destructive interference. In phase shift type blankmasks, it is common to refer to the absorber film as a phase shift film to distinguish it from binary type blankmasks. However, since the blankmask of the present invention includes both binary type blankmasks and phase shift type blankmasks, the term 'absorber film' in the present invention is used as a collective term referring not only to the absorber film in binary type blankmasks but also to the phase shift film in phase shift blankmasks. Furthermore, the blankmask of the present invention includes not only 0.33NA blankmasks but also high NA blankmasks of 0.55NA or higher.

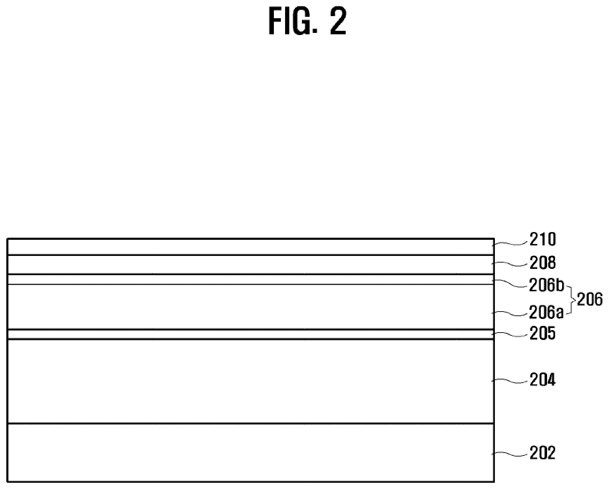

FIG. 2 is a diagram illustrating the film structure of a blankmask for extreme ultraviolet lithography according to the present invention. The blankmask for extreme ultraviolet lithography according to the present invention comprises a substrate 202, a reflective film 204 formed on the substrate 202, a capping film 205 formed on the reflective film 204, an absorber film 206 formed on the capping film 205, a hard mask film 208 formed on the absorber film 206, and a resist film 210 formed on the hard mask film 208. Additionally, the blankmask of the present invention may include additional films such as a conductive film (not shown) formed on the rear surface of the substrate 202.

The substrate 202 is composed of a LTEM (Low Thermal Expansion Material) substrate having a low thermal expansion coefficient within the range of 0±1.0×10⁻⁷/°C to prevent pattern deformation and stress due to heat during exposure, preferably within the range of 0±0.3×10⁻⁷/°C, suitable as a glass substrate for reflective type blankmasks using EUV exposure light. SiO₂-TiO₂ based glass, multi-component glass ceramic, etc. can be used as the material for the substrate 202.

The reflective film 204 has the function of reflecting EUV exposure light and has a multilayer structure with different refractive indices for each layer. Specifically, the reflective film 204 is formed by alternately stacking 40-60 layers of Mo material and Si material. The reflective film 204 preferably has a reflectance of 60% or more, preferably 64% or more for EUV exposure light of 13.5nm.

The capping film 205 prevents oxide film formation on the reflective film 204 to maintain the reflectance of the reflective film 204 for EUV exposure light, and protects the reflective film 204 during patterning of the absorber film 206. Generally, the capping film 205 is formed of a material containing ruthenium (Ru). The capping film 205 has a thickness of 2-5nm.

The absorber film 206 is patterned in the process of manufacturing a photomask from the blankmask, and exposes the capping film 205 in the portions removed by patterning. The absorber film 206 absorbs exposure light, and accordingly the exposure light is divided into portions reflected by the reflective film 204 and portions absorbed by the absorber film 206 to be irradiated onto the wafer.

The absorber film 206 is formed of a material that absorbs exposure light, and tantalum (Ta) is used as the base material for such materials. The absorber film 206 may include additional metals along with Ta, such as molybdenum (Mo) or titanium (Ti). Additionally, the absorber film 206 may further include one or more of boron (B), oxygen (O), and nitrogen (N). Tantalum (Ta) has the property of being etched by chlorine-based gas, and when oxygen (O) is additionally included with tantalum (Ta), it has the property of being etched by fluorine-based gas.

The absorber film 206 may have a single-layer structure. When the absorber film 206 has a single-layer structure, the absorber film 206 consists of a continuous film with the uppermost portion formed of a material that is etched by fluorine-based etching gas.

The absorber film 206 may also have a structure of two or more layers. In the embodiment of FIG. 2, the absorber film has a two-layer structure, specifically, the lower layer of the absorber film 206 consists of an absorber layer 206a and the upper layer consists of an inspection layer 206b. The absorber layer 206a functions to absorb EUV exposure light, and the inspection layer 206b is used to inspect the completed blankmask using 193nm ArF inspection light.

The inspection layer 206b is formed of a material containing oxygen (O) for reflectance reduction by 193nm inspection light. For example, the inspection layer 206b may be formed of TaO, TaBO, TaON, TaBON. As described above, since Ta is etched by fluorine-based gas when it contains oxygen (O), the inspection layer 206b is etched by fluorine-based etching gas. As will be described below, the hard mask film 208 is etched by chlorine-based gas, and accordingly the inspection layer 206b has an etching selectivity with respect to the hard mask film 208. The inspection layer 206b preferably has a minimum thickness for the inspection function, for example a thickness of 2-5nm.

The absorber layer 206a functions to absorb exposure light with a wavelength of 13.5nm. The absorber layer 206a preferably contains tantalum (Ta) but does not contain oxygen (O) so that it is etched by chlorine-based gas. For example, the absorber layer 206a may be formed of TaB or TaBN. Since the absorber layer 206a is etched by chlorine-based gas, it has an etching selectivity with respect to the inspection layer 206b. As will be described below, since the hard mask film 208 is also etched by chlorine-based gas, the hard mask film 208 is removed by etching during etching for patterning the absorber layer 206a.

The hard mask film 208 functions as an etching mask for patterning the inspection layer 206b below it. For this purpose, the hard mask film 208 is composed of a material having etching selectivity with respect to the inspection layer 206b, specifically, the hard mask film 208 is composed of a material that is etched by chlorine-based etching gas. Furthermore, the hard mask film 208 must be composed of a material that is etched by chlorine-based gas without oxygen (O₂) to solve the problem in the conventional art.

In the present invention, a material containing chromium (Cr), niobium (Nb), oxygen (O), and nitrogen (N) is presented as a material that solves the above problems. The inventors of the present invention discovered that when niobium (Nb) is mixed with chromium (Cr), the hard mask film 208 can be etched by chlorine-based gas without oxygen (O₂).

Specifically, the hard mask film 208 is preferably configured to contain Cr:Nb = 3:7 - 7:3 in at% ratio, and more preferably configured to contain Cr:Nb = 4:6 - 6:4 in at% ratio. When the Nb content is lower than this ratio, the etching rate by oxygen-free chlorine-based gas is relatively slow, making it difficult to thin the resist film 210, and when the Nb content is higher than this ratio, resistance to cleaning solutions such as SPM deteriorates.

The hard mask film 208 preferably secures an etching rate of 3.0Å/sec or more in chlorine-based gas, and has an etching selectivity of 8:1 or more with respect to the inspection layer 206b below it. Additionally, the hard mask film 208 preferably has chemical stability such that the thickness change after cleaning process is 5Å or less with respect to cleaning solutions such as SPM.

When one or more of nitrogen (N) and oxygen (O) are added to the hard mask film 208, the etching rate, etching selectivity, and resistance to cleaning solutions can be controlled through content adjustment. According to experimental results, as the oxygen (O) content increases, the etching rate for chlorine-based gas increases, but the etching rate for fluorine-based gas also increases, so the etching selectivity rather decreases above a certain content. Additionally, it was confirmed that there is a proportional relationship between nitrogen (N) content and stability to cleaning solutions, but an inverse relationship between oxygen (O) content and stability to cleaning solutions. Therefore, the oxygen (O) content is preferably less than a specific ratio.

The inventors of the present invention conducted optimization experiments on the above three characteristics, namely etching rate, etching selectivity, and resistance to cleaning solutions, while changing the composition of oxygen (O) and nitrogen (N) with the Cr:Nb ratio set to the above-described range, and confirmed that the above three conditions are satisfied when the XRR (X-ray reflectivity) measured density of CrNbON film with certain composition ratios is in the range of 5.0-6.5g/cm³. Additionally, XRD (X-ray Diffraction) measurement results of CrNbON film in the above density range showed that the FWHM (Full Width at Half Maximum) of the main peak existing in the range of 2θ 40° or less is 2.0 or more, confirming that this CrNbON film is in an amorphous state sufficient for securing excellent profile.

To ensure that the CrNbON film has the measured density in the above range, while setting the Cr:Nb content ratio to the above range, the composition ratio of each element in the finally formed film is controlled by appropriately adjusting the content of oxygen and nitrogen in the sputtering process for film formation. At this time, the content of Cr, Nb, O, N elements that yield the measured density in the above range can be composed of various value combinations.

The resist film 210 is composed of Chemically Amplified Resist (CAR). In the present invention, the resist film 210 may have a thickness of 30-60nm.

The process of manufacturing a photomask using the blankmask of the present invention having the above configuration is as follows.

First, a reflective film 204, capping film 205, absorber layer 206a, inspection layer 206b, hard mask film 208, and resist film 210 are sequentially formed on the substrate 202. After exposing and patterning the resist film 210, the hard mask film 208 is patterned using the patterned resist film 210 as an etching mask. At this time, chlorine-based gas without oxygen (O₂), such as Cl₂ and/or BCl₃, is used for the etching process of the hard mask film 208.

After the patterning of the hard mask film 208 is completed, the resist film 210 is removed. The resist film 210 can be removed by over-etching of the hard mask film 208 without a separate removal process. After the resist film 210 is removed, the inspection layer 206b is etched and patterned using the hard mask film 208 as an etching mask. Fluorine-based etching gas, such as SF₆, is used for patterning the inspection layer 206b.

After the patterning of the inspection layer 206b is completed, the absorber layer 206a is patterned using the hard mask film 208 and inspection layer 206b as etching masks. At this time, chlorine-based gas without oxygen (O₂), such as Cl₂ and/or BCl₃, is used for the etching process of the absorber layer 206a. While the absorber layer 206a is being etched, the pattern of the hard mask film 208 is removed by the etching gas that etches the absorber layer 206a.

Through such processes, the photomask manufacturing process using the blankmask of the present invention is completed.

According to the present invention, sufficient etching rate of the hard mask film 208 can be obtained even using only chlorine-based etching gas without oxygen (O₂) in the process of manufacturing photomask using EUV blankmask equipped with the absorber film and the hard mask films. Compared to etching the conventional CrCON material hard mask film 108 with oxygen (O₂)-containing chlorine-based gas, when etching the CrNbON material hard mask film 208 of the present invention with oxygen (O₂)-free chlorine-based gas, it was confirmed that the etching rate improved by about 1.2-2.0 times.

According to the present invention, damage to the resist film 210 caused by oxygen (O₂) is prevented, enabling thinning of the resist film 210. When etching the conventional hard mask film 108 containing only Cr with oxygen (O₂)-containing chlorine-based gas, the thickness of the resist film 110 must be set to sufficient thickness, for example at least 80nm or more, considering damage to the resist film 110 by oxygen (O₂). However, in the present invention, since oxygen (O₂)-free etching gas is used, damage to the resist film 210 is significantly reduced, and therefore sufficient thickness for etching the hard mask film 208 can be secured even when the thickness of the resist film 210 is set to 60nm or less.

Furthermore, when attempting to improve pattern precision through over-etching with the conventional hard mask film 108, the resist film 110 must be formed with a thick thickness of about 100nm considering damage to the resist film 110, but in the present invention, it is possible to over-etch the hard mask film 208 even when forming the resist film 210 with a thickness of about 60nm or thinner at 50nm. Therefore, pattern precision improvement by over-etching can be achieved while thinning the resist film 210.

Additionally, according to the present invention, since the capping film 205 is not exposed to oxygen (O₂) in the process of removing the hard mask film 208, reflectance reduction due to damage to the capping film 205 is prevented.

Furthermore, according to the present invention, since the hard mask film 208 is removed during etching of the absorber layer 206a, there is an advantage that no additional process for removing the hard mask film 208 is needed.

Although details of the disclosure have been described above through a few embodiments of the disclosure with reference to the accompanying drawings, the embodiments are merely for the illustrative and descriptive purposes only but not construed as limiting the scope of the disclosure defined in the appended claims. It will be understood by a person having ordinary skill in the art that various changes and other equivalent embodiments may be made from these embodiments. Thus, the scope of the invention should be defined by the technical subject matters of the appended claims.

## Claims

1. A blankmask for extreme ultraviolet lithography comprising:
a substrate;
a reflective film formed on the substrate;
a capping film formed on the reflective film;
an absorber film formed on the capping film; and
a hard mask film formed on the absorber film, containing chromium (Cr), niobium (Nb), oxygen (O), and nitrogen (N), and having an XRR (X-ray reflectivity) measured density of 5.0-6.5g/cm³.

2. The blankmask of claim 1, wherein the hard mask film is **characterized in that** an FWHM (Full Width at Half Maximum) of main peak existing in a range of 2θ 40° or less as measured by XRD (X-ray Diffraction) is 2.0 or more.

3. The blankmask of claim 2, wherein the hard mask film contains Cr:Nb = 3:7 - 7:3 at% ratio.

4. The blankmask of claim 2, wherein the hard mask film contains Cr:Nb = 4:6 - 6:4 at% ratio.

5. The blankmask of any one of claims 1 to 4, wherein at least an uppermost part of the absorber film is etched by fluorine-based etching gas.

6. The blankmask of claim 5, wherein
the absorber film includes an absorber layer disposed on the capping film and an inspection layer disposed on the absorber layer, and
the inspection layer is etched by fluorine-based gas and the absorber layer is etched by chlorine-based gas without oxygen (O₂).

7. The blankmask of claim 6, wherein
the inspection layer contains tantalum (Ta) and oxygen (O), and
the absorber layer contains tantalum (Ta) and does not contain oxygen (O).

8. A photomask manufactured using the blankmask of any one of claims 1 to 7.
